(19) Europäisches Patentamt
European Patent Office
Office européen des brevets

(11) EP 4 368 751 A1

(12) EUROPEAN PATENT APPLICATION
published in accordance with Art. 153(4) EPC

(43) Date of publication:
15.05.2024 Bulletin 2024/20

(51) International Patent Classification (IPC):
C30B 15/12 (2006.01)    C30B 29/06 (2006.01)

(21) Application number: 22852009.4

(52) Cooperative Patent Classification (CPC):
C30B 15/12; C30B 29/06

(22) Date of filing: 27.07.2022

(86) International application number:
PCT/CN2022/108342

(87) International publication number:
WO 2023/011295 (09.02.2023 Gazette 2023/06)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 02.08.2021 CN 202121785718 U
02.08.2021 CN 202121790057 U

(71) Applicant: Longi Green Energy Technology Co., Ltd.
Xi'an, Shaanxi 710100 (CN)

(72) Inventors:
• YAO, Hong
Shaanxi 710100 (CN)
• ZHANG, Chaoguang
Shaanxi 710100 (CN)
• REN, Weikang
Shaanxi 710100 (CN)

• CHENG, Lei
Shaanxi 710100 (CN)
• LI, Qiao
Shaanxi 710100 (CN)
• CHENG, Lu
Shaanxi 710100 (CN)
• DENG, Hao
Shaanxi 710100 (CN)
• ZHAO, Linghang
Shaanxi 710100 (CN)
• DUAN, Bin
Shaanxi 710100 (CN)
• DU, Lulu
Shaanxi 710100 (CN)
• HAN, Wei
Shaanxi 710100 (CN)

(74) Representative: Loo, Chi Ching et al
Albright IP Limited
County House
Bayshill Road
Cheltenham, Gloucestershire GL50 3BA (GB)

(54) CRUCIBLE ASSEMBLY AND THERMAL FIELD ASSEMBLY

(57) A crucible assembly and a thermal field assembly, the crucible assembly comprising a crucible holder; a crucible slope which is arranged on the crucible holder, the crucible slope having a crucible mounting cavity that gradually expands from the crucible holder in a direction away from the crucible holder; and a crucible which is arranged in the crucible mounting cavity, an outer side surface of the crucible being an outer side surface that gradually increases from the crucible holder in the direction away from the crucible holder, the outer side surface being arranged opposite an inner side surface of the crucible mounting cavity, and the crucible slope having a softening temperature higher than that of the crucible. According to the above solution, the crucible slope and the crucible can easily be separated, thereby avoiding damage to the crucible slope and improving the production safety.

FIG. 1

Description

CROSS-REFERENCE TO RELATED APPLICATION

This application claims priority to Chinese patent application No. 202121785718.8 entitled "Crucible Combination", filed with the China National Intellectual Property Administration (CNIPA) on August 2, 2021, and Chinese patent application No.202121790057.8 entitled "Crucible and Thermal Field Assembly", filed with the CNIPA on August 2, 2021, which are incorporated herein by reference in their entirety.

TECHNICAL FIELD

This application generally relates to the technical field of silicon rod preparation, in particular to a crucible combination and a thermal field assembly.

BACKGROUND

In order to cope with the depletion of fossil energy sources in the future, various countries around the world have begun to focus on the development of renewable energy sources such as photovoltaic energy. Especially in recent years, the monocrystalline photovoltaic industry has developed rapidly. For monocrystalline photovoltaics, the silicon material needs to be melted first, and the polycrystalline silicon material is refined into a monocrystalline silicon rod through seeding. The working temperature at this stage exceeds 1400°C, and the working area is filled with a large amount of silicon vapor. Due to complex environmental conditions, it is difficult for ordinary high temperature resistant materials to work for a long time, which easily leads to production accidents.

In order to achieve a continuous operation in a high temperature environment to ensure a smooth running of the crystal pulling process for forming silicon rods, a crucible combination with a composite structure is used to heat and melt the silicon material. Existing crucible combinations with composite structures generally include a susceptor holder, a susceptor body is provided on the susceptor holder. The susceptor body has a cylindrical cavity, and a crucible with a cylindrical outer circumferential surface is disposed in the cavity. The cylindrical outer circumferential surface of the crucible and the cylindrical inner circumferential surface of the susceptor body match with each other.

After the process is completed, the crucible needs to be replaced. This is because that the susceptor body is generally a Carbon-Carbon Composite Material (CC) susceptor body and the crucible is generally a quartz crucible, at the high working temperature mentioned above, the crucible will undergo a plastic deformation and stick tightly to the CC susceptor body. At a cooling stage, since the CC susceptor body has a coefficient of thermal expansion far more than that of the quartz crucible, the CC crucible expanded at the high temperature stage will undergo a bursting strength from the internal quartz crucible during the cooling process. After the quartz crucible is cooled to the room temperature, its deformation cannot return to the original state. As a result, the CC susceptor body is held up by the internal crucible and cannot be removed. The current solution is to thwack the quartz crucible manually by the employees after the furnace is shut down and cooled down, so that the quartz crucible is completely destroyed, and the CC susceptor body is removed finally. On the one hand, such process is time-consuming and labor-intensive, and it is extremely difficult to take out the CC susceptor body. On the other hand, since a thwack is required, cracks easily occur on the susceptor body during the thwack, which may affect the service life of the CC susceptor body, or even may cause production accidents.

SUMMARY

In view of the above-mentioned defects or shortcomings in the related art, it is desired to provide a crucible combination and a thermal field assembly to solve the problems in the related art that the susceptor body is hard to be separated from the crucible, and the susceptor body is easily damaged, posing safety production risks.

In a first aspect, the present application provides a crucible combination, including:

a susceptor holder;
a susceptor body disposed on the susceptor holder, wherein the susceptor body includes a crucible installation cavity that gradually increases from the susceptor holder in a direction departing from the susceptor holder; and
a crucible disposed in the crucible installation cavity, wherein an outer surface of the crucible is an outer surface that gradually increases from the susceptor holder in the direction departing from the susceptor holder, the outer surface and an inner surface of the crucible installation cavity are arranged oppositely, and a softening temperature of the susceptor body is greater than the softening temperature of the crucible.

As a feasible way, a bottom of the susceptor body includes an opening, a top portion of the susceptor holder is exposed from the opening, the bottom of the crucible is located in the opening, and a lower surface of the bottom of the crucible is in contact with a top surface of the susceptor holder; or,

the bottom of the susceptor body is enclosed and supported on the top surface of the susceptor holder, the upper surface of the bottom of the susceptor body is in contact with the lower surface of the bottom of the crucible.

As a feasible way, an inner surface of the crucible installation cavity is in close fit or clearance fit with an outer surface of the crucible.

As a feasible way, in the case that the inner surface of the crucible installation cavity is in clearance fit with the outer surface of the crucible, a gap between the inner surface of the crucible installation cavity and the outer surface of the crucible is D, and 0mm < D≤4mm.

As a feasible way, the crucible installation cavity is in a shape of an inverted frustum, an angle between a generatrix and a center line of the inverted frustum is α, and 1°≤α≤ 10°.

As a feasible way, a top portion of the crucible is higher than a top portion of the susceptor body.

As a feasible way, a thickness of walls of the crucible is 10mm~30mm and/or the thickness of walls of the susceptor body is 10mm~50mm.

As a feasible way, an outer peripheral surface of the susceptor holder is circular, and the thickness of the outer peripheral surface of the susceptor holder is greater than 20 mm.

As a feasible way, the susceptor holder is a CC susceptor holder or a graphite susceptor holder; the susceptor body is a CC susceptor body or a graphite susceptor body; the crucible is a quartz crucible or a silicon carbide crucible.

As a feasible way, the density of the CC susceptor holder and the CC susceptor body is 1.35g/cm$^3$ to 1.5g/cm$^3$; the density of the graphite susceptor holder and the graphite susceptor body is 1.6g/cm$^3$ to 2.33g/cm$^3$.

As a feasible way, the crucible includes a main body, the main body includes a bottom wall with a cavity, the cavity is provided with an opening at the top, an inner surface of the cavity is in a shape of a minor arc spherical crown or a hemispherical surface, and the thickness of the bottom wall gradually decreases from a center of the inner surface of the cavity toward the opening.

As a feasible way, the main body further includes a first sidewall arranged along a circumference of the opening, the first sidewall and the bottom wall are integrally connected at the opening, and an inner rim at an end of the first sidewall connected to the bottom wall coincides with an inner rim at the opening of the bottom wall, the first sidewall extends about the axis of the crucible in a direction facing away from the bottom wall, and an outer diameter of the first sidewall is uniform.

As a feasible way, the thickness of the first sidewall is uniform, or, along the axial direction of the crucible, the thickness of the first sidewall gradually decreases from the opening to an end facing away from the bottom wall.

As a feasible way, a height of the first sidewall along the axis of the crucible is 30 mm to 100 mm.

As a feasible way, the thickness of the bottom wall satisfies the following relationship:

$$Y = 12.574\text{-}0.07195X\text{-}2.11*10^{-4}\,X^2\,\text{-}2.605*10^{-7}\,X^3;$$

wherein, X is a distance from the opening of the crucible to any position on the crucible in an axial direction of the crucible, X is negative, and Y is the thickness of the bottom wall at a position corresponding to X.

As a feasible way, an inner diameter of the bottom wall is greater than 600mm.

In a second aspect, the present application provides a thermal field assembly, including:

the crucible combination described above;

a heat shield disposed above the crucible, wherein the axis of the crucible coincides with the axis of the heat shield, the heat shield includes a first outer sidewall disposed in the circumferential direction, and a second outer sidewall in the shape of spherical zone is provided on an end of the first outer sidewall facing the crucible; outer diameters of cross sections of the second outer sidewall perpendicular to the axis of the crucible decrease sequentially in a direction from an end of the second outer sidewall close to the first outer sidewall 11 to the end away from the first outer sidewall; the heat shield includes a crystal pulling channel, and both the first outer sidewall and the second outer sidewall are located outside the crystal pulling channel.

As a feasible way, the outer diameter of the spherical zone matches the inner diameter of the bottom wall.

As a feasible way, a third outer sidewall in the shape of an inverted frustum of cone is provided at an end of the second outer sidewall facing the crucible along the circumferential direction, the third outer sidewall is tangent to the second outer sidewall at a connection point between the third outer sidewall and the second outer sidewall, and the third outer sidewall is located outside the crystal pulling channel.

As a feasible way, a sum of the heights of the second outer sidewall and the third outer sidewall in the axial direction of the crucible is less than the radius of the spherical zone.

As a feasible way, the susceptor holder and the susceptor body enclose a supporting cavity in the shape of a minor arc spherical crown, the crucible is supported in the supporting cavity, and the outer surface of the bottom wall is a minor arc spherical crown or hemispherical surface with a radius equal to the radius of the supporting cavity.

As a feasible way, the heat shield includes an outer tank, and the outer tank is a CC outer tank or a graphite outer tank.

In the above solution provided by the present application, the outer surface of the crucible, that gradually increases from the susceptor holder in the direction departing from the susceptor holder, corresponds to the inner surface of the crucible installation cavity that gradually increases from the susceptor holder in the direction departing from the susceptor holder, after the crystal pulling process is completed, the susceptor body and the crucible cool down and shrink, the outer surface of the crucible, that gradually increases from the susceptor holder in the direction departing from the susceptor holder, is in fit with the inner surface of the crucible installation cavity that gradually increases from the susceptor holder in the direction departing from the susceptor holder, a normal force Fn and a friction force Fs are applied on the outer surface of the crucible that gradually increases from the susceptor holder in the direction departing from the susceptor holder, then in the vertical direction y, the crucible receives an upward force $\Sigma Fy=Fny-Fsy$, where the normal force Fn is from the inner surface of the crucible installation cavity that gradually increases from the crucible holder in the direction departing from the crucible holder, and is perpendicular to the outer surface of the crucible that gradually increases from the susceptor holder in the direction departing from the susceptor holder , the friction force Fs is a declivous force along the outer surface of the crucible that gradually increases from the susceptor holder in the direction departing from the susceptor holder. In this way, when the susceptor body and crucible cool down and shrink, such force enables the crucible to move upward, thereby easing the interaction between the susceptor body and the crucible, and preventing the susceptor body and the crucible from locking and being unable to separate from each other. Therefore, it is not necessary to separate the susceptor body and the crucible through thwacking, which can avoid damage to the susceptor body during the thwacking, the damage to the susceptor body results in safety production risks.

## BRIEF DESCRIPTION OF THE DRAWINGS

In order to explain technical solutions of the embodiments of the present disclosure more clearly, accompanying drawings used in the illustration of the embodiments will be briefly introduced. Apparently, the accompanying drawings in the following explanation illustrate merely some embodiments of the present disclosure, and those skilled in the art may obtain other accompanying drawings based on these accompanying drawings without paying any creative effort.

FIG. 1 is a schematic structural diagram illustrating a crucible combination provided by an embodiment of the present application;

FIG. 2 is a schematic structural diagram illustrating a crucible provided by an embodiment of the present application;

FIG. 3 is a schematic diagram illustrating forces on the crucible provided by an embodiment of the present application;

FIG. 4 is a schematic perspective view illustrating a crucible provided by an embodiment of the present application;

FIG. 5 is a schematic perspective view illustrating a crucible provided by another embodiment of the present application;

FIG. 6 is a schematic structural diagram illustrating a thermal field assembly provided by an embodiment of the present application;

FIG. 7 is a schematic structural diagram illustrating a thermal field assembly provided by another embodiment of the present application; and

FIG. 8 is a schematic structural diagram illustrating a thermal field assembly provided by yet another embodiment of the present application.

## DETAILED DESCRIPTION OF THE EMBODIMENTS

The present application will be further described in detail below in conjunction with the accompanying drawings and embodiments. It can be understood that the specific embodiments described herein are only used to explain the relevant application, but not to limit the present application. In addition, it should also be noted that, for convenience of description, only parts relevant to the application are shown in the drawings.

It should be noted that, as long as there is no conflict, the embodiments and features in the embodiments of the present application can be combined with each other. The present application will be described in detail below with reference to the accompanying drawings and embodiments.

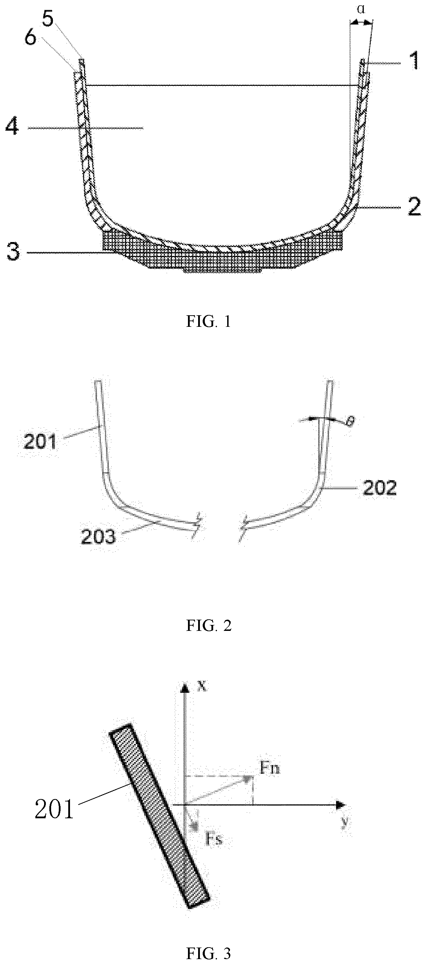

In a first aspect, as shown in FIG. 1 and FIG. 2, the crucible combination provided by the embodiments of the present application includes a susceptor holder 3 and a susceptor body 2.

The susceptor holder 3, when being used, is placed on a crucible rotating tray, and is served as a supporting member to support the susceptor body 2, a crucible 1 and silicon material 4 to be placed in the crucible 1. The crucible rotating tray drives the susceptor holder 3 to rotate, and the susceptor body 2 and the crucible 1 rotate synchronously along with the susceptor holder 3 to perform the crystal pulling operation.

The susceptor body 2 is disposed on the susceptor holder 3. The susceptor body 2 includes a crucible installation cavity that gradually increases from the susceptor holder in a direction departing from the susceptor holder, and the softening temperature of the susceptor body 2 is greater than the softening temperature of the crucible 1 described below. The susceptor body 2 is configured to support the crucible 1 at least in an axial direction. Since the softening temperature of the susceptor body 2 is greater than the softening temperature of the crucible 1 described below, the silicon material inside the crucible 1 is prevented from flowing out due to the softening of the crucible 1 in high temperature environments.

Herein, gradually increasing from the susceptor holder in the direction departing from the susceptor holder refers to a structure with a small end located at the bottom and a big end located at the top. The slope of a side edge of the structure that gradually increases from the susceptor holder in the direction departing from the susceptor holder may be linear or nonlinear. When the slope of the side edge of the structure that gradually increases from the susceptor holder in the direction departing from the susceptor holder is linear, the side edge of the structure is a straight line. In this case, the structure that gradually increases from the susceptor holder in the direction departing from the susceptor holder is an inverted frustum. The inverted frustum refers to a frustum with a small end located at the bottom and a big end located at the top. The frustum refers to a stereoscopic structure between two parallel planes, which is obtained by cutting a cone or pyramid by the two parallel planes, that is, the frustum herein may be a polygonal frustum or a frustum of a cone. When the slope of the side edge of the structure that gradually increases from the susceptor holder in the direction departing from the susceptor holder is non-linear, the side edge of the structure that gradually increases from the susceptor holder in the direction departing from the susceptor holder is in an arc or an elliptical arc, etc. The softening temperature refers to the temperature at which a component undergoes the plastic deformation due to heat.

The crucible 1 is disposed in the crucible installation cavity. An outer surface of the crucible 1 is an outer surface 201 that gradually increases from the susceptor holder in the direction departing from the susceptor holder. The outer surface 201 and an inner surface of the crucible installation cavity are arranged oppositely, that is, the crucible 1 and the susceptor body 2 are in bushing fit with each other in a structure that gradually increases from the susceptor holder in the direction departing from the susceptor holder. Generally, the crucible 1 includes a cambered bottom 203, and the cambered bottom 203 is smoothly connected to the outer surface 201 through a cambered transition section 202.

In the above solution provided by the present application, the outer surface 201 of the crucible, that gradually increases from the susceptor holder in the direction departing from the susceptor holder, corresponds to the inner surface of the crucible installation cavity that gradually increases from the susceptor holder in the direction departing from the susceptor holder. After the crystal pulling process is completed, the susceptor body 2 and the crucible 1 cool down and shrink, and the outer surface 201 of the crucible 1, that gradually increases from the susceptor holder in the direction departing from the susceptor holder, is attached to the inner surface of the susceptor body 2 that gradually increases from the susceptor holder in the direction departing from the susceptor holder. As shown in FIG. 3, a normal force Fn and a friction force Fs are applied on the outer surface 201 of the crucible 1 that gradually increases from the susceptor holder in the direction departing from the susceptor holder, then in the vertical direction y, the crucible 1 receives an upward force $\Sigma Fy=Fny-Fsy$, where the normal force Fn is from the inner surface of the crucible installation cavity that gradually increases from the susceptor holder in the direction departing from the susceptor holder, and is perpendicular to the outer surface 201 of the crucible 1 that gradually increases from the susceptor holder in the direction departing from the susceptor holder, the friction force Fs is a declivous force along the outer surface 201 of the crucible 1 that gradually increases from the susceptor holder in the direction departing from the susceptor holder. In this way, when the susceptor body 2 and the crucible 1 cool down and shrink, such force enables the crucible 1 to move upward, thereby easing the interaction between the susceptor body 2 and crucible 1, and preventing the susceptor body 2 and the crucible 1 from locking and being unable to separate from each other. Therefore, it is not necessary to separate the susceptor body and the crucible through thwacking, which can avoid damage to the susceptor body 2 during the thwacking, the damage to the susceptor body results in safety production risks.

As a feasible way, the bottom of the susceptor body 2 includes an opening through which the top portion of the susceptor holder 3 is exposed, the bottom of the crucible 1 is located in the opening, and the lower surface of the bottom of the crucible 1 is in contact with the top surface of the susceptor holder 3. With this structure, the bottom of the susceptor body 2 is open, that is, the bottom of the susceptor body 2 includes an opening. When separating the crucible 1, such structure is convenient for separating the crucible 1 from the susceptor body 2 by placing the susceptor body 2 upside down, that is, with the small diameter end of the structure gradually increasing from the susceptor holder in the direction departing from the susceptor holder upward, and taping the crucible 1 downward in the opening.

Alternatively, the bottom of the susceptor body 2 is enclosed and supported on the top surface of the susceptor holder 3, the upper surface of the bottom of the susceptor body 2 is in contact with the lower surface of the bottom of the crucible 1.

As a feasible way, the surface of the crucible installation cavity and the outer surface of the crucible 1 are in tight fit or in clearance fit. Generally, the inner surface of the crucible installation cavity is preferably in clearance fit with the outer surface of the crucible 1, so as to facilitate the assembly of the crucible 1 into the susceptor body 2.

As a feasible way, when the inner surface of the crucible installation cavity and the outer surface of the crucible 1 are in a clearance fit state, the gap between the inner surface of the crucible installation cavity and the outer surface of the crucible 1 is D, and 0mm < D≤4mm. By adopting such gap, the crucible 1 can be easily mounted into the susceptor body 2. Moreover, during operation, the crucible 1 may be attached to the inner surface of the susceptor body 2 when minor deformation occurs on the crucible, and the susceptor body 2 can well support the side surface of the crucible 1, thereby preventing the silicon material in the crucible 1 from flowing out due to softening and deformation of the crucible 1.

As a feasible way, the crucible installation cavity is in a shape of an inverted frustum, and an angle between the generatrix and the center line of the inverted frustum is $\alpha$, and 1°≤$\alpha$≤10°. Correspondingly, the angle between the outer surface 201 that gradually increases from the susceptor holder in the direction departing from the susceptor holder and the center line of the crucible 1, is $\theta$, and 1°≤$\theta$≤10°. Such angles can ensure that the susceptor body 2 and the crucible 1 are easily separated, and the susceptor body 2 can also be prevented from being damaged by excessive stress due to a large downward component force when the angles are too large.

As a feasible way, a top portion 5 of the crucible 1 is higher than a top portion 6 of the susceptor body 2, so that the problem, that the purity of the silicon rod is affected due to the material of the susceptor body 2 that peeled off in a high temperature environment and dropped into the crucible 1, is prevented during the crystal pulling operation.

As a feasible way, the thickness of the wall of the crucible 1 is 10mm to 30mm and/or the thickness of the wall of the susceptor body 2 is 10mm to 50mm, so that the production cost of the crucible 1 and the susceptor body 2 is reduced by reducing the materials used for making the crucible 1 and the susceptor body 2 as much as possible while ensuring the crucible 1 and the susceptor body 2 to meet the necessary mechanical properties.

As a feasible way, an outer peripheral surface of the susceptor holder 3 is circular, and the thickness thereof is greater than 20 mm.

As a feasible way, the susceptor holder 3 is a CC susceptor holder or a graphite susceptor holder; the susceptor body 2 is a CC susceptor body or a graphite susceptor body; and the crucible 1 is a quartz crucible or a silicon carbide crucible.

The susceptor holder 3 and the susceptor body 2 are preferably made of CC materials, that is, a CC susceptor holder and a CC susceptor body are used. By using the CC materials, the susceptor holder 3 and the susceptor body 2 are ensured to have better mechanical properties under high temperature conditions (for example, greater than 1000°C) and have a good thermal conductivity and a low thermal expansibility.

As a feasible way, the density of the CC susceptor holder and the CC susceptor body is 1.35g/cm$^3$ to 1.5g/cm$^3$; the density of the graphite susceptor holder and the graphite susceptor body is 1.6g/cm$^3$ to 2.33g/cm$^3$. The above density ranges are adopted so as to not only ensure the susceptor body 2 and the susceptor holder 3 to have sufficient strength, but also a certain degree of economy is ensured. Excessively high density will cause a significant increase in cost, and the corresponding increase in strength has exceeded the strength requirements of this solution. Therefore, within the above density range, both the strength requirements and the economic requirements are met, which is conducive to industrial application.

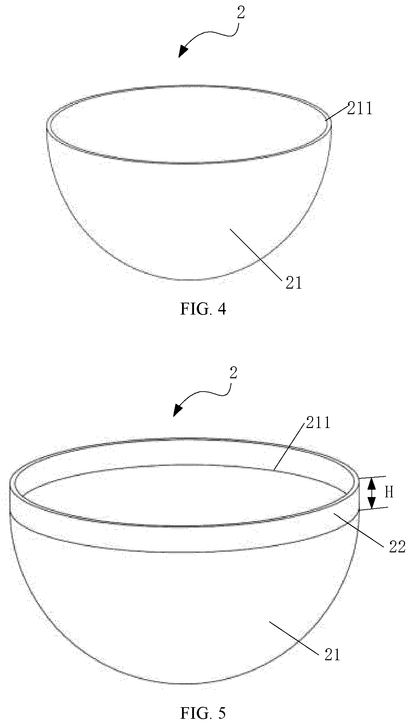

As a feasible way, as shown in FIG. 4, the crucible 2 provided by the embodiment of the present application includes a main body.

The main body includes a bottom wall 21. The bottom wall 21 has a cavity with an opening at the top. The inner surface of the bottom wall 21 is in the shape of a minor arc spherical crown or a hemispherical surface, and the thickness of the bottom wall 21 gradually decreases from the center of the inner surface of the cavity toward the opening of the cavity.

That is to say, the bottom surface of the bottom wall 21 is the thickest at the center thereof, and becomes thinner toward the outside. Depending on various actual usages, in order to meet the strength requirements of the crucible 2, the rim of the bottom wall 21 needs to have a certain thickness. In this example, the thickness of the rim of the bottom wall 21 is generally greater than 12mm.

The minor arc spherical crown mentioned herein refers to the smaller one of two spherical crowns formed by dividing a spherical surface with a plane that does not pass through the center of the sphere, that is, the spherical crown whose top surface curve is a minor arc.

In the above solution provided by this application, the structure of the bottom wall 21 is in the shape of a minor arc spherical crown or a hemispherical surface, the transition between various parts of the bottom wall is relatively smooth and uniform, and the stress is good, which can increase the service life of the crucible 2. Meanwhile, the minor arc spherical crown or hemispherical structure reduces the contact area between the molten silicon and the crucible 2, the contact area between the crucible 2 and the molten silicon is reduced by at least 8%. Accordingly, silicon monoxide generated by the reaction between the crucible 2 and the molten silicon is reduced, so that the oxygen dissolved in the molten silicon reduces, ultimately achieving the purpose of reducing the oxygen content of the silicon rod. For example, the oxygen content is reduced by at least 1 ppma. In addition, since the thickness of the bottom wall 21 gradually decreases from the center of the inner surface to the opening, the reaction rate with the molten silicon at different parts of the crucible 2 varies. The thermal resistance of the bottom of the bottom wall (that is, the thickened part) increases, and the reaction rate slows down, which further reduces the oxygen content in the molten silicon and improves the quality of the silicon rod produced.

As a feasible way, as shown in FIG. 5, the main body further includes a first sidewall 22 provided along the circumferential direction of the opening. The first sidewall 22 and the bottom wall 21 are integrally connected at the opening, that is, the first sidewall 22 is a ring that is connected to the opening of the bottom wall 21 and is in a connected state. Moreover, the inner rim at an end of the first sidewall 22 connected to the bottom wall 21 coincides with the inner rim 211 at the opening of the bottom wall 21. The first sidewall 22 extends about the axis of the crucible in a direction facing away from the bottom wall 21, and the outer diameter of the first sidewall 22 is uniform. By arranging the first sidewall 22 with the uniform outer diameter, during the fabrication processing of the crucible 2, the bottom wall 21 can be processed by clamping the outer surface of the first sidewall 22, which is beneficial to improving the accuracy of the minor arc spherical crown or hemispherical structure of the inner surface of the bottom wall 21. The ring mentioned herein may have an equal diameter or a variable diameter. In the case that the ring has a variable diameter, the inner diameter is changed. The cross-sectional shape of the ring may be circular, elliptical, quadrilateral, polygonal, etc., which will not be unique limited here, and may be determined according to specific usage conditions. For example, if the ring of the first sidewall 22 adopts a structure with equal diameters and a circular cross-section, then the first sidewall 22 has a circular tubular structure, and the inner and outer diameters of the first sidewall 22 are uniform respectively, that is, the first sidewall has an uniform thickness. Assuming the ring of the first sidewall 22 adopts a structure with a variable diameter and a circular cross-section, the first sidewall 22 is a variable diameter circular tube, and if the diameter is changed in a linear relationship, then the structure of the hole of the variable diameter circular tube is a tapered tube, that is, along the axial direction of the crucible, the thickness of the first sidewall 22 gradually decreases from the opening to the end away from the bottom wall 21.

In addition, since the inner rim at an end of the first sidewall 22 connected to the bottom wall 21 coincides with the inner rim 211 at the opening of the bottom wall 21, the thickness of the crucible gradually decreases from the center of the inner surface of the cavity toward the end of the first sidewall 22 facing away from the bottom wall 21, and the thermal resistance at various parts can be further adjusted to slow down the reaction rate at the bottom of the crucible. Therefore, the oxygen content in the melted silicon is further reduced, and the quality of the silicon rod produced is improved.

As a feasible way, the height H of the first sidewall 22 along the axis direction of the crucible is 30 mm to 100 mm, so that the first sidewall 22 is fully clamped by the clamper for processing the crucible 2, thereby preventing the reduction of the processing accuracy due to looseness during the processing.

As a feasible way, the thickness of the bottom wall satisfies the following relationship:

$$Y = 12.574\text{-}0.07195X\text{-}2.11*10^{-4} X^2\text{-}2.605*10^{-7} X^3;$$

wherein, X is a distance from the opening of the crucible to any position of the crucible in the axial direction of the crucible, and X is negative, and Y is the thickness of the bottom wall at a position corresponding to X. When the thickness of the bottom wall satisfies the above relationship, it can ensure uneven temperature and uneven corrosion in the crucible to the greatest extent, and the oxygen reduction effect is improved. For example, but not limited to, the thickness of the bottom wall 21 is in a range of 12 mm to 25 mm. A good thermal conductivity can be ensured by adopting the thickness range, on the one hand, the energy consumption can be reduced, and on the other hand, the temperature in the crucible 2 is prevented from being too high. Since an excessively high temperature in the crucible 2 will intensify the silicon monoxide generated by the reaction between the crucible 2 and the molten silicon, the problem of an increase in the oxygen content in the molten silicon caused by the excessively high temperature in the crucible 2 can be avoided.

As a feasible way, the inner diameter of the bottom wall 21 is greater than 600 mm, so as to ensure that more silicon materials can be filled in the crucible 2 during one crystal pulling process.

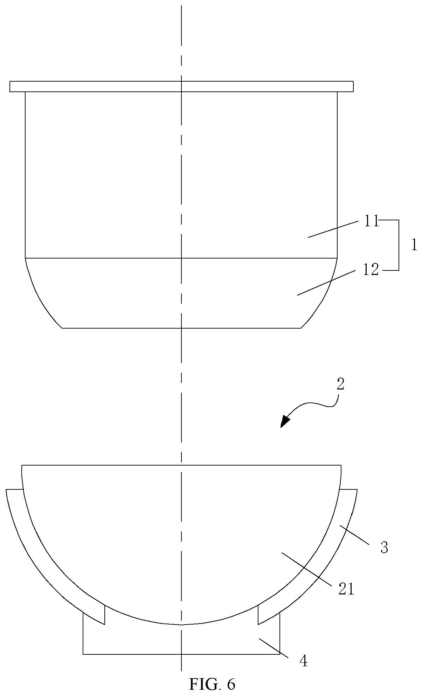

In a second aspect, as shown in FIG. 6, an embodiment of the present application provides a thermal field assembly, including:

the crucible 2 in the above embodiments, the specific structure of which can be found in the embodiments described above, and will not be described here; and

a heat shield 1 disposed above the crucible 2, and the axis of the crucible 2 coincides with the axis of the heat shield 1. The heat shield 1 includes a first outer sidewall 11 disposed in the circumferential direction, and a second outer sidewall 12 in the shape of spherical zone is provided on an end of the first outer sidewall 11 facing the crucible. The outer diameters of the cross sections of the second outer sidewall 12 perpendicular to the axis of the crucible decrease sequentially in a direction from the end of the second outer sidewall 12 close to the first outer sidewall 11 to the end away from the first outer sidewall 11. The heat shield 1 has a crystal pulling channel, and both the first outer sidewall 11 and the second outer sidewall 12 are located outside the crystal pulling channel. Generally, the heat shield 1 may include an outer tank and an inner tank disposed inside the outer tank. The crystal pulling channel is a hollow channel in the inner tank. The first outer sidewall 11 and the second outer sidewall 12 are a part of the outer tank. Of course, in other embodiments, the heat shield 1 may have only an outer tank, then the crystal pulling channel is a hollow channel in the outer tank, and the first outer sidewall 11 and the second outer sidewall 12 are a part of the outer tank.

The spherical zone mentioned here refers to a part of a spherical surface sandwiched between two parallel sections.

During the crystal pulling process, the heat shield 1 is fixed, and the crucible 2 rotates around the vertical axis and gradually rises along the vertical axis, thus by arranging the vertical axis of the crucible 2 to coincide with the vertical axis of the heat shield 1, damages to the crucible 2 and/or the heat shield 1 caused by the collision between the crucible 2 and the heat shield 1 during rotation are avoided. Moreover, the distance between the crucible 2 and the heat shield 1 may be reduced as much as possible to facilitate the full utilization of the silicon materials in the crucible 2, thereby reducing the amount of remaining material in the crucible 2 during the crystal pulling process, and reducing the cost of crystal pulling.

In the above solution provided by the present application, the inner surface of the bottom wall 21 is in a structure of a minor arc spherical crown or a hemispherical surface. The transition between various parts of the inner surface of the bottom wall 21 is relatively smooth and even, and the stress is good, which can increase the service life of the crucible 2. Meanwhile, the minor arc spherical crown or hemispherical structure reduces the contact area between the molten silicon and the crucible 2, the contact area between the crucible 2 and the molten silicon is reduced by at least 8%. Accordingly, the silicon monoxide generated by the reaction between the crucible 2 and the molten silicon is reduced, so that the oxygen dissolved in the molten silicon becomes less, and the object of reducing the oxygen content of the silicon rod is achieved ultimately. For example, the oxygen content is reduced by at least 1 ppma. In addition, since the thickness of the bottom wall 21 gradually decreases from the center of the inner surface to the opening of the bottom wall 211, the reaction rate of the molten silicon and the crucible 2 varies at different parts of the crucible 2. The thermal resistance of the bottom of the bottom wall (that is, the thickened part) increases, and the reaction rate slows down, which further reduces the oxygen content in the molten silicon and improves the quality of the silicon rod produced.

Furthermore, the outer diameter of the spherical zone matches the inner diameter of the bottom wall 21 so that the crucible can move upward as close to the lower part of the heat shield as possible, thereby minimizing the amount of remaining material in the crucible 2 and reducing the cost of crystal pulling. The outer diameter of the spherical zone and the inner diameter of the bottom wall 21 being matched with each other means that the outer diameter of the spherical zone is equal to the inner diameter of the bottom wall 21, or the outer diameter of the spherical zone is slightly less than the inner diameter of the bottom wall 21, and the specific value less than the inner diameter of the bottom wall 21 is determined according to the actual situation.

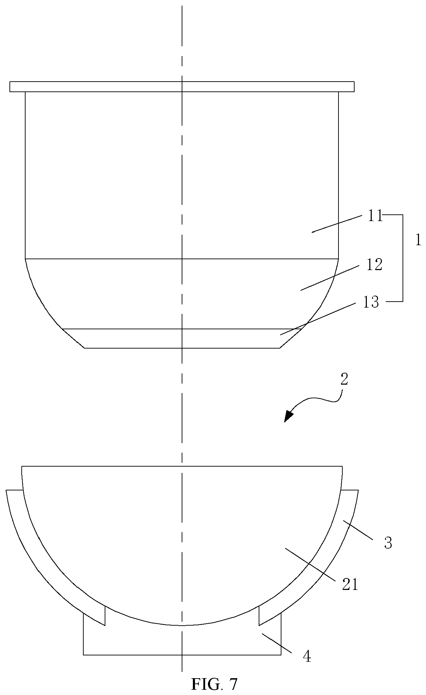

As a feasible way, as shown in FIG. 7, in order to further reduce the amount of remaining material in the crucible 2 during the crystal pulling process and reduce the cost of crystal pulling, a third outer sidewall 13 in the shape of an inverted frustum of cone is provided at an end of the second outer sidewall 12 facing the crucible 2 along the circumferential direction, the third outer sidewall 13 is tangent to the second outer sidewall 12 at a connection point between the third outer sidewall and the second outer sidewall, and the third outer sidewall 13 is located outside the crystal pulling channel. Since the third outer sidewall 13 in the shape of the inverted frustum of cone is provided at the lower end of the second outer sidewall 12, the distance difference between the second outer sidewall 12 and the bottom surface of the bottom wall 21 can be compensated, and the distance between the lowest end of the heat shield 1 and the bottom surface of the bottom wall 21 is reduced. Therefore, the molten silicon in the bottom wall 21 can be pulled away to the maximum extent to form a silicon rod during the crystal pulling process, thereby minimizing the amount of remaining material in the bottom wall 21 (that is, the crucible 2), and reducing the cost of crystal pulling.

As a feasible way, a sum of the heights of the second outer sidewall 12 and the third outer sidewall 13 in the axial direction of the crucible 2 is smaller than the radius of the spherical zone. In this way, when the crucible 2 rises to the maximum height position, there is still a certain distance between the bottom of the third outer sidewall 13 and the bottom wall 21, so as to avoid the damage to the crucible 2 and/or the heat shield 1 caused by the lower end of the third outer sidewall 13 abutting against the crucible 2.

As a feasible way, the thermal field assembly further includes:

a susceptor holder 4; and
a susceptor body 3 disposed on the susceptor holder 4, the susceptor holder 4 and the susceptor body 3 enclose a supporting cavity in the shape of a minor arc spherical crown, the crucible 2 is supported in the supporting cavity, and the outer surface of the bottom wall 21 is a minor arc spherical crown or hemispherical surface with a radius equal to the radius of the supporting cavity. Then, the outer surface of the bottom wall may be in perfect contact with the support cavity, which can reduce the pressure at the contact point and prevent the crucible 2, the susceptor body 3 and the susceptor holder 4 from being damaged due to excessive pressure at the contact point.

In addition, since the susceptor holder 4 and the susceptor body 3 enclose a minor arc spherical crown supporting cavity, and the bottom wall 21 is a minor arc spherical crown or hemispherical surface, then the surface where the bottom wall 21, that is, the crucible 2, cooperates with the susceptor body 3 is a flared surface, and the upper end of the flared surface is large and the lower end of the flared surface is small. After the crystal pulling process is completed, the susceptor body 3 and the crucible 2 cool down and shrink, and the minor arc spherical crown or hemispherical surface of the crucible 2 fits the inner surface of the susceptor body 3, so that a positive pressure perpendicular to the outer surface of the minor arc spherical crown or hemispherical surface is applied by the flared surface on the outer surface of the minor arc spherical crown or hemispherical surface, and an oblique downward friction force is applied on the minor arc spherical crown or hemispherical outer surface. Then, the crucible 2 receives an upward force in the vertical direction. In this way, when the susceptor body 3 and crucible 2 cool down and shrink, such force enables the crucible 2 to move upward, thereby easing the interaction between the susceptor body 3 and crucible 2, and preventing the susceptor body 3 and crucible 2 from locking and being unable to separate from each other. Therefore, it is not necessary to separate the susceptor body and crucible through thwacking, which can avoid damage to the susceptor body 3 during the thwacking, the damage to the susceptor body results in safety production risks.

As a feasible way, in the axis direction of the crucible 2, the top portion of the crucible 2 is higher than the top portion of the susceptor body 3, so that the problem, that the purity of the silicon rod is affected due to the material of the susceptor body 3 peeled off in a high temperature environment and dropped into the crucible 1, is prevented during the crystal pulling operation.

As a feasible way, the susceptor holder 4 is a CC susceptor holder 4 or a graphite susceptor holder 4; the susceptor body 3 is a CC susceptor body 3 or a graphite susceptor body 3; the crucible 2 is a quartz crucible 2 or a silicon carbide crucible 2; the heat shield 1 includes an outer bladder that is a CC outer container or a graphite outer container.

The susceptor holder 4 and the susceptor body 3 are preferably made of CC materials, that is, a CC susceptor holder 4 and a CC susceptor body 3 are used. By using CC materials, the susceptor holder 4 and the susceptor body 3 are ensured to have better mechanical properties under high temperature conditions (for example, greater than 1000°C). Moreover, the susceptor holder 4 and the susceptor body 3 also have good thermal conductivity to save energy and reduce consumption, and also have lower thermal expansibility.

As a feasible way, the density of the CC susceptor holder 4 and the CC susceptor body 3 is in a range from $1.35g/cm^3$ to $1.5g/cm^3$; the density of the graphite susceptor holder 4 and the graphite susceptor body 3 is in a range from $1.6g/cm^3$ to $2.33g/cm^3$. The above density ranges are adopted so as to not only ensure that the susceptor body 3 and the susceptor holder 4 have sufficient strength, but also ensure a certain degree of economy. Excessively high density will cause a significant increase in cost, and the corresponding increase in strength has exceeded the strength requirements of this solution. Therefore, within the above density range, both the strength requirements and the economic requirements are met, which is conducive to industrial application.

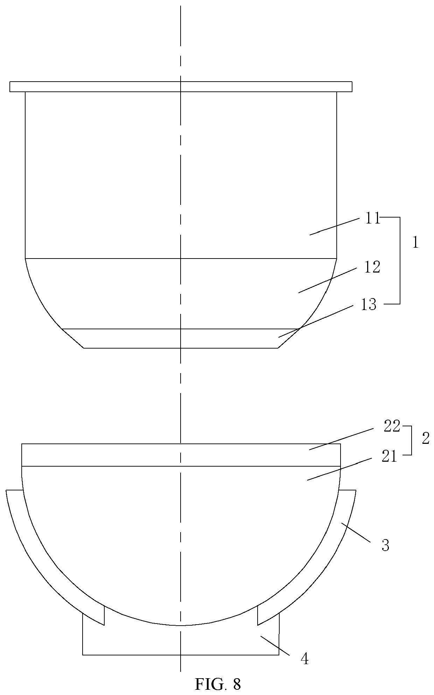

As shown in FIG. 8, the difference between the thermal field assembly shown in FIG. 8 and the thermal field assembly shown in FIG. 7 mainly lies in that the crucibles 2 used are different. The crucible 2 used in the example of FIG. 7 does not include the first sidewall 22, and the crucible 2 used in the example of FIG. 8 includes the first sidewall 22.

It should be understood, the orientation or positional relationship indicated by terms involved above, such as "center", "longitudinal", "landscape", "upper", "lower", "front", "back", "left", "right", "vertical" , "horizontal", "top", "bottom", "inside", "outside", is based on the orientation or positional relationship shown in the drawings, and is only for the convenience of describing the present application and simplifying the description, rather than indicating or implying that the device or element referred to must have a specific orientation, be constructed and operate in a specific orientation, and therefore cannot be construed as a limitation on the present application. In addition, the terms "first" and "second" are only used for descriptive purposes and cannot be understood as indicating or implying relative importance or implicitly indicating the quantity of indicated technical features. Therefore, features defined as "first" and "second" may explicitly or implicitly include one or more of these features. In the description of the embodiments of the present disclosure, unless otherwise specified, "plurality" means two or more.

The above is only an explanation of preferred embodiments of the present application and the technical principles used. Those skilled in the art should understand that the scope of the application involved in this application is not limited to technical solutions composed of specific combinations of the above technical features, but should also cover other technical solutions formed by any combination of the above technical features or equivalent features thereof without departing from the concept of the disclosure, for example, a technical solution formed by replacing the above features with technical features with functions similar to that disclosed (but not limited to) in this application.

**Claims**

1. A crucible combination, comprising:

   a susceptor holder;
   a susceptor body disposed on the susceptor holder, wherein the susceptor body comprises a crucible installation cavity that gradually increases from the susceptor holder in a direction departing from the susceptor holder; and
   a crucible disposed in the crucible installation cavity, wherein an outer surface of the crucible is an outer surface that gradually increases from the susceptor holder in the direction departing from the susceptor holder, the outer surface and an inner surface of the crucible installation cavity are arranged oppositely, and a softening temperature of the susceptor body is greater than the softening temperature of the crucible.

2. The crucible combination according to claim 1, wherein a bottom of the susceptor body comprises an opening, a top portion of the susceptor holder is exposed from the opening, the bottom of the crucible is located in the opening, and a lower surface of the bottom of the crucible is in contact with a top surface of the susceptor holder; or,
   the bottom of the susceptor body is enclosed and supported on the top surface of the susceptor holder, the upper surface of the bottom of the susceptor body is in contact with the lower surface of the bottom of the crucible.

3. The crucible combination according to claim 2, wherein the inner surface of the crucible installation cavity is in close fit or clearance fit with the outer surface of the crucible.

4. The crucible combination according to claim 3, wherein in the case that the inner surface of the crucible installation cavity is in clearance fit with the outer surface of the crucible, a gap between the inner surface of the crucible installation cavity and the outer surface of the crucible is D, and 0mm<D≤4mm.

5. The crucible combination according to any one of claims 1 to 4, wherein the crucible installation cavity is in a shape of an inverted frustum, an angle between a generatrix and a center line of the inverted frustum is $\alpha$, and 1°≤$\alpha$≤10°.

6. The crucible combination according to any one of claims 1 to 4, wherein a top portion of the crucible is higher than a top portion of the susceptor body.

7. The crucible combination according to any one of claims 1 to 4, wherein a thickness of walls of the crucible is 10mm to 30mm and/or the thickness of walls of the susceptor body is 10mm to 50mm.

8. The crucible combination according to any one of claims 1 to 4, wherein an outer peripheral surface of the susceptor holder is circular, and the thickness of the outer peripheral surface of the susceptor holder is greater than 20 mm.

9. The crucible combination according to any one of claims 1 to 4, wherein the susceptor holder is a Carbon-Carbon Composite Material (CC) susceptor holder or a graphite susceptor holder; the susceptor body is a CC susceptor body or a graphite susceptor body; the crucible is a quartz crucible or a silicon carbide crucible.

10. The crucible combination according to claim 9, wherein a density of the CC susceptor holder and the CC susceptor body is 1.35g/cm$^3$~1.5g/cm$^3$; the density of the graphite susceptor holder and the graphite susceptor body is 1.6g/cm$^3$~2.33g/cm$^3$.

11. The crucible combination according to claim 1, wherein the crucible comprises a main body, the main body comprises a bottom wall with a cavity, the cavity is provided with an opening at the top, the inner surface of the cavity is in a shape of a minor arc spherical crown or a hemispherical surface, and a thickness of the bottom wall gradually decreases from a center of the inner surface of the cavity toward the opening.

12. The crucible combination according to claim 11, wherein the main body further comprises a first sidewall disposed along a circumferential direction of the opening, the first sidewall and the bottom wall are integrally connected at the opening, and an inner rim at an end of the first sidewall connected to the bottom wall coincides with an inner rim at the opening of the bottom wall, the first sidewall extends about the axis of the crucible in a direction departing from the bottom wall, and an outer diameter of the first sidewall is uniform.

13. The crucible combination according to claim 12, wherein the thickness of the first sidewall is uniform, or, along the axial direction of the crucible, the thickness of the first sidewall gradually decreases from the opening to an end away from the bottom wall.

14. The crucible combination according to claim 12 or 13, wherein a height of the first sidewall along the axis direction of the crucible is 30 mm~100 mm.

15. The crucible combination according to any one of claims 11 to 13, wherein the thickness of the bottom wall satisfies the following relationship:

$$Y = 12.574 - 0.07195X - 2.11*10^{-4} X^2 - 2.605*10^{-7} X^3;$$

wherein, X is a distance from the opening of the crucible to any position on the crucible in the axial direction of the crucible, X is negative, and Y is the thickness of the bottom wall at a position corresponding to X.

16. The crucible combination according to any one of claims 11 to 13, wherein an inner diameter of the bottom wall is greater than 600mm.

17. A thermal field assembly, comprises:

the crucible combination according to any one of claims 11 to 16;
a heat shield disposed above the crucible, wherein the axis of the crucible coincides with the axis of the heat shield, the heat shield comprises a first outer sidewall disposed in the circumferential direction, and a second outer sidewall in the shape of spherical zone is provided on an end of the first outer sidewall facing the crucible; outer diameters of cross sections of the second outer sidewall perpendicular to the axis of the crucible decrease sequentially in a direction from an end of the second outer sidewall close to the first outer sidewall to the end away from the first outer sidewall; the heat shield comprises a crystal pulling channel, and both the first outer sidewall and the second outer sidewall are located outside the crystal pulling channel.

18. The thermal field assembly according to claim 17, wherein the outer diameter of the spherical zone matches the inner diameter of the bottom wall.

19. The thermal field assembly according to claim 17, wherein a third outer sidewall in the shape of an inverted frustum of cone is provided at an end of the second outer sidewall facing the crucible along the circumferential direction, the third outer sidewall is tangent to the second outer sidewall at a connection point between the third outer sidewall and the second outer sidewall, and the third outer sidewall is located outside the crystal pulling channel.

20. The thermal field assembly according to claim 19, wherein a sum of the heights of the second outer sidewall and the third outer sidewall in the axial direction of the crucible is less than a radius of the spherical zone.

21. The thermal field assembly according to any one of claims 17 to 20, wherein the susceptor holder and the susceptor body enclose a supporting cavity in the shape of a minor arc spherical crown, the crucible is supported in the supporting cavity, and the outer surface of the bottom wall is a minor arc spherical crown or hemispherical surface with a radius equal to the radius of the supporting cavity.

22. The thermal field assembly according to claim 21, wherein the heat shield comprises an outer tank, and the outer tank is a CC outer tank or a graphite outer tank.

FIG. 1

FIG. 2

FIG. 3

2

211

21

FIG. 4

2

211

H

22

21

FIG. 5

FIG. 6

FIG. 7

FIG. 8

## INTERNATIONAL SEARCH REPORT

| International application No. |
| --- |
| **PCT/CN2022/108342** |

**A. CLASSIFICATION OF SUBJECT MATTER**

C30B 15/12(2006.01)i; C30B 29/06(2006.01)i

According to International Patent Classification (IPC) or to both national classification and IPC

**B. FIELDS SEARCHED**

Minimum documentation searched (classification system followed by classification symbols)

C30B15/-, C30B29/-

Documentation searched other than minimum documentation to the extent that such documents are included in the fields searched

Electronic data base consulted during the international search (name of data base and, where practicable, search terms used)

CNPAT, CNKI, WPI, EPODOC, STN, ISI: 坩埚, 锅帮, 锥, 侧壁, 锅托, crucible, holding, supporting, conical

**C. DOCUMENTS CONSIDERED TO BE RELEVANT**

| Category* | Citation of document, with indication, where appropriate, of the relevant passages | Relevant to claim No. |
| --- | --- | --- |
| PX | CN 216006085 U (LONGJI GREEN ENERGY TECHNOLOGY CO., LTD.) 11 March 2022 (2022-03-11) <br> claims 1-10 | 1-10 |
| PX | CN 215800038 U (LONGJI GREEN ENERGY TECHNOLOGY CO., LTD.) 11 February 2022 (2022-02-11) <br> description, paragraphs 0034-0062 | 1-22 |
| Y | GB 816334 A (TELEFUNKEN GMBH) 08 July 1959 (1959-07-08) <br> description, p. 1, right-hand column, line 64 to p. 2, left-hand column, line 15, and drawings | 1-22 |
| Y | CN 206814881 U (NINGXIA LONGI SILICON MATERIALS CO., LTD.) 29 December 2017 (2017-12-29) <br> description, paragraph 0015, and figure 3 | 1-22 |
| A | CN 203007474 U (XI'AN LONGI SILICON MATERIALS CORP. et al.) 19 June 2013 (2013-06-19) <br> claims 1-8 | 1-22 |
| A | CN 201463538 U (KBC CORPORATION LTD.) 12 May 2010 (2010-05-12) <br> claims 1-4 | 1-22 |

☑ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **10 October 2022** | **27 October 2022** |

| Name and mailing address of the ISA/CN | Authorized officer |
| --- | --- |
| **China National Intellectual Property Administration (ISA/ CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

International application No.

**PCT/CN2022/108342**

**C.      DOCUMENTS CONSIDERED TO BE RELEVANT**

| Category* | Citation of document, with indication, where appropriate, of the relevant passages | Relevant to claim No. |
|---|---|---|
| A | CN 101571351 A (IBIDEN CO., LTD.) 04 November 2009 (2009-11-04) claims 1-10 | 1-22 |

Form PCT/ISA/210 (second sheet) (January 2015)

# EP 4 368 751 A1

**INTERNATIONAL SEARCH REPORT**
**Information on patent family members**

| | International application No. |
|---|---|
| | **PCT/CN2022/108342** |

| Patent document cited in search report | | | Publication date (day/month/year) | Patent family member(s) | | | Publication date (day/month/year) |
|---|---|---|---|---|---|---|---|
| CN | 216006085 | U | 11 March 2022 | None | | | |
| CN | 215800038 | U | 11 February 2022 | None | | | |
| GB | 816334 | A | 08 July 1959 | None | | | |
| CN | 206814881 | U | 29 December 2017 | None | | | |
| CN | 203007474 | U | 19 June 2013 | None | | | |
| CN | 201463538 | U | 12 May 2010 | None | | | |
| CN | 101571351 | A | 04 November 2009 | US | 2009272314 | A1 | 05 November 2009 |
| | | | | JP | 2009269777 | A | 19 November 2009 |
| | | | | KR | 20090115680 | A | 05 November 2009 |
| | | | | EP | 2113588 | A1 | 04 November 2009 |
| | | | | EP | 2206810 | A2 | 14 July 2010 |
| | | | | AT | 551447 | T | 15 April 2012 |
| | | | | TW | 200946852 | A | 16 November 2009 |

Form PCT/ISA/210 (patent family annex) (January 2015)

19

**REFERENCES CITED IN THE DESCRIPTION**

**Patent documents cited in the description**

- CN 202121785718

- CN 202121790057